# EUROPÄISCHE PATENTANMELDUNG

(11) **EP 2 595 073 A1**
(43) Veröffentlichungstag der Anmeldung: **22.05.2013**
(21) Anmeldenummer: 11189887.0
(22) Anmeldetag: 21.11.2011
(51) Int. Cl.: G06F 17/50

(54) **Verfahren zur Optimierung eines Guss-Bauteils mit heterogenem Gefüge**

(71) Anmelder: Siemens Aktiengesellschaft, 80333 München (DE); Winergy AG, 46562 Voerde (DE)
(72) Erfinder: Klein-Hitpass, Arno, 52074 Aachen (DE); Meis, Jean-Andre, 48249 Duelmen (DE); Tenbrink, Michael, 46399 Bocholt (DE)

(57) **Zusammenfassung**

Die Erfindung betrifft ein Verfahren zur Optimierung eines Guss-Bauteils (100) mit heterogenem Gefüge unter Berücksichtigung von Anforderungen hinsichtlich einer lokalen Härte (102) zum Zwecke einer Herstellung eines Guss-Bauteils (100), aufweisend folgende Verfahrensschritte:
a. computergestützte Simulation (104) eines Prototyps (106) des Guss-Bauteils unter Vorgabe von Kennwerten für eine mechanische Beanspruchung (108) und eine benötigte lokale Härte (102) des Guss-Bauteils (100),
b. virtuelle Beanspruchungsanalyse (110) des simulierten Prototyps (106) für das Guss-Bauteil (100) zur Ermittlung einer simulierten lokalen Härte (112) des Guss-Bauteils (100), wobei eine Streckgrenze (114) und eine Zugfestigkeit (116) lokaler Punkte des Prototyps (106) simuliert werden, wobei sich aus der Streckgrenze (114) und/oder der Zugfestigkeit (116) die simulierte lokale Härte (112) ergibt, wobei durch Vergleich der lokalen Härte (102) und der simulierten lokalen Härte (112) Schwachstellen (118) im Prototyp (106) bestimmt werden, wobei die Schwachstellen dadurch identifiziert werden, dass eine erste Toleranzgrenze (120) der lokalen Härte (112) überschritten wird,
c. Wiederholung der Schritte a bis b bis die vordefinierten Grenzwerte eingehalten werden, wobei der Prototyp (106) hinsichtlich der lokalen Härte (112) optimiert wird,
d. Berechnung von lokalen Strukturveränderungen des optimierten Prototyps nach Wirkung der mechanischen Beanspruchung (122), wobei in die Berechnung die simulierte lokale Härte (112) eingeht, wobei der optimierte Prototyp (106) zur Vermeidung der Strukturveränderungen (124) weiter optimiert wird durch Anpassung der benötigten lokalen Härte (112) und/oder einer Gefügestruktur (126) und/oder einer geometrischen Form (128) des Prototyps (106),
e. Wiederholung der Schritte a bis d so lange bis alle Strukturveränderungen (124) innerhalb vordefinierter zweiter Toleranzgrenzen liegen.

## Beschreibung

Die Erfindung betrifft ein Verfahren zur Optimierung eines Guss-Bauteils mit heterogenem Gefüge unter Berücksichtigung von Anforderungen hinsichtlich einer lokalen Härte zum Zwecke einer Herstellung eines Guss-Bauteils.

Die lokale Festigkeit und/oder lokale Beanspruchbarkeit eines Maschinenbauteils ist von einer Vielzahl von Einflussfaktoren abhängig. Diese werden in der Regel empirisch ermittelt und in Beziehung zu Normwerten gesetzt, so dass sich Reduktionsfaktoren ergeben, welche zur Quantifizierung einer relativen Festigkeit und/oder einer relativen lokalen Beanspruchbarkeit eines Bauteils dienen.

Im Stand der Technik erfolgt eine Bestimmung einer Festigkeit von Maschinenbauteilen mittels spezifischer Kenngrößen, welche von genormten Kenngrößen abgeleitet werden. So wird beispielsweise die Festigkeit von großen Guss-Bauteilen mittels Bestimmung einer Härte, einer Kerbschlagarbeit oder einer Zugfestigkeit bzw. einer Streckgrenze ermittelt.

Werte für diese Kenngrößen werden in der Regel durch Messungen an Probekörpern ermittelt. Beispielsweise werden bei der Bestimmung der Festigkeit von großen Guss-Bauteilen Messungen an mit- oder angegossenen Proben vorgenommen, um Werte für die Kennwerte zur Bestimmung der Festigkeit und/oder der Beanspruchbarkeit zu ermitteln.

Dabei wird zur Vereinfachung unterstellt, dass die an den Proben gemessenen Werte für das gesamte Guss-Bauteil gelten. Das ist aber in der Regel nicht der Fall. Denn in großen Guss-Bauteilen beispielsweise können sich aufgrund lokal unterschiedlicher Abkühlgeschwindigkeiten des Materials und weiterer lokal differierender technologischer Parameter erhebliche Gradienten in den Werkstoffeigenschaften des Guss-Bauteils ergeben.

Bei der Auslegung und Produktion solcher strukturell inhomogener Guss-Bauteile mit lokal differierenden Werkstoffeigenschaften ergeben sich somit erhebliche Probleme, um spezifische angeforderte lokale Qualitätsanforderungen zu erfüllen. Denn die für die Auslegung eines Guss-Bauteils angesetzten Materialkennwerte werden nicht nur von den lokalen Gefügeeigenschaften des Guss-Bauteils, sondern auch von den herstellprozessbedingten lokal vorliegenden Materialentartungen des Guss-Bauteils bestimmt. Im Stand der Technik werden dennoch Qualitätsanforderungen pauschal für ein gesamtes Guss-Bauteil oder zumindest große Bauteilbereiche vorgegeben. Um den global geforderten Qualitätsanforderungen entgegen zu kommen, werden die mechanischen Werkstoffeigenschaften über das gesamte Bauteil annähernd dadurch homogenisiert, dass das Bauteil einer teuren Wärmebehandlung unterzogen wird. Gussfehler wie Gefügeentartungen oder Poren lassen sich auf diese Weise jedoch nicht oder nur in sehr geringem Maße beheben. Eine lokal begrenzte Gefügeungänze kann aber dazu führen, dass das gesamte Guss-Bauteil Ausschuss wird.

Im Stand der Technik gibt es noch keine zuverlässlichen und gültigen Methode zur Bestimmung von Kennwerten für eine Betriebsfestigkeit eines Guss-Bauteils. Bisher werden für eine Berechnung einer Betriebsfestigkeit eines Guss-Bauteils aus vorhandenen Kennwerten empirische Abschlagsfaktoren gebildet, wobei Erfahrungswerte und eine Vielzahl von vorhergehenden Untersuchungen mit einbezogen werden. Da dies mit Unsicherheiten verbunden ist, werden zusätzliche Sicherheitszuschläge z.B. bei den Gestaltparametern mit einkalkuliert. Dies kann in eine Überdimensionierung des Guss-Bauteils resultieren. Im schlimmsten Falle kann es zu einem totalen Versagen des Guss-Bauteils hinsichtlich seiner geforderten Anforderungen kommen.

Es liegt der Erfindung die Aufgabe zugrunde, ein verbessertes Verfahren zur Optimierung eines Guss-Bauteils mit heterogenem Gefüge unter Berücksichtigung von Anforderungen hinsichtlich einer lokalen Härte zum Zwecke einer Herstellung eines Guss-Bauteils, eine verbesserte Vorrichtung zur Optimierung eines Guss-Bauteils mit heterogenem Gefüge unter Berücksichtigung von Anforderungen hinsichtlich einer lokalen Härte zum Zwecke einer Herstellung eines Guss-Bauteils sowie ein verbessertes Computerprogrammprodukt zu schaffen.

Die der Erfindung zugrunde liegenden Aufgaben werden jeweils mit den Merkmalen des unabhängigen Patentanspruchs gelöst. Bevorzugte Ausführungsformen der Erfindung sind in den abhängigen Patentansprüchen angegeben.

Es wird ein Verfahren zur Optimierung eines Guss-Bauteils mit heterogenem Gefüge unter Berücksichtigung von Anforderungen hinsichtlich einer lokalen Härte zum Zwecke einer Herstellung eines Guss-Bauteils geschaffen, aufweisend folgende Verfahrensschritte:
a. computergestützte Simulation eines Prototyps des Guss-Bauteils unter Vorgabe von Kennwerten für eine mechanische Beanspruchung und eine benötigte lokale Härte des Guss-Bauteils,
b. virtuelle Beanspruchungsanalyse des simulierten Prototyps für das Guss-Bauteil zur Ermittlung einer simulierten lokalen Härte des Guss-Bauteils, wobei eine Streckgrenze und eine Zugfestigkeit lokaler Punkte des Prototyps simuliert werden, wobei sich aus der Streckgrenze und/oder der Zugfestigkeit die simulierte lokale Härte ergibt, wobei durch Vergleich der lokalen Härte und der simulierten lokalen Härte Schwachstellen im Prototyp bestimmt werden, wobei die Schwachstellen dadurch identifiziert werden, dass eine erste Toleranzgrenze der lokalen Härte überschritten wird,
c. Wiederholung der Schritte a bis b bis die vordefinierten Grenzwerte eingehalten werden, wobei der Prototyp hinsichtlich der lokalen Härte optimiert wird,
d. Berechnung von lokalen Strukturveränderungen des optimierten Prototyps nach Wirkung der mechanischen Beanspruchung, wobei in die Berechnung die simulierte lokale Härte eingeht, wobei der optimierte Prototyp zur Vermeidung der Strukturveränderungen weiter optimiert wird durch Anpassung der benötigten lokalen Härte und/oder einer Gefügestruktur und/oder einer geometrischen Form des Prototyps,
e. Wiederholung der Schritte a bis d so lange bis alle Strukturveränderungen innerhalb vordefinierter zweiter Toleranzgrenzen liegen.

Dies kann den Vorteil haben, dass eine computergestützte Bestimmung einer Härte eines Guss-Bauteils mit heterogenem Gefüge lokal und punktuell ermöglicht wird. Ein Guss-Bauteil könnte folglich bei gleichzeitiger Reduzierung der Anzahl von Auslegungsparametern für seine Gesamtkonstruktion durch eine eingeschränkte Zahl von identifizierten kritischen Lokalitäten hinsichtlich einer geforderten lokalen mechanischen Beanspruchung gezielt punktuell optimiert werden. Ausführungsformen der Erfindung beschränken sich somit nicht nur auf eine globale Analyse.

Durch computergestützte Berechnungen und eine virtuelle Beanspruchungsanalyse können die Auslegungsparameter eines herzustellenden Guss-Bauteils hinsichtlich einer lokal geforderten Härte durch eine virtuelle Simulation der geometrischen Form und/oder seiner Gefügestruktur zur Erreichung einer geforderten lokalen Härte optimiert werden, ohne zunächst physikalisch reales Material zu verbrauchen. In den ersten Phasen eines Entwurfs eines Guss-Bauteils werden dadurch erhebliche Material- und Herstellungskosten sowie Zeit gespart.

Durch virtuelles lokales Einwirken einer Extremlast und/oder Simulation einer fiktiven Nutzungsdauer eines Prototyps für das herzustellende Guss-Bauteil können kausale Beziehungen zwischen Form, Gefügestruktur und/oder lokaler Härte des Prototyps und Kennwerten für eine mechanische Beanspruchung hergeleitet werden. Gleichzeitig können durch eine Extremlast oder eine lange Nutzungsdauer induzierte lokale Strukturveränderungen in der Gefügestruktur des simulierten Prototyps (z.B. eine irreversible plastische Verformung oder ein Bruch) im Voraus berechnet werden, wobei gleichzeitig individuelle Belastungsgrenzen des jeweils konfigurierten Prototyps ermittelt werden können. Diese ermittelten Beziehungen und Grenzwerte können für eine Optimierung eines herzustellenden Guss-Bauteils mit heterogenem Gefüge durch Veränderung der relevanten Auslegungsparameter verwendet werden, ohne tatsächliches Material zu verbrauchen.

Als Gefüge bezeichnet man in der Werkstoffkunde rein beschreibend eine Anordnung der Bestandteile von aus Schmelzen entstandenen Stoffen wie Metallen und Legierungen. Ein Gefüge entsteht, wenn die Schmelze eines kristallinen Stoffes abkühlt. Beim Erreichen der Erstarrungstemperatur kommt es an vielen Stellen innerhalb der Schmelze, ausgehend von zufällig entstandenen Kristallisationskeimen, zur Kristallbildung. Im Nachgang der Erstarrung der Schmelze kommt es aufgrund der vorhandenen Restwärme zu einer quasi "unfreiwilligen" Wärmebehandlung, was als Selbstanlassen bezeichnet wird. Ein Selbstanlassen, wie auch eine technische Wärmebehandlung, führt zu weiteren Umwandlungs-, Ausscheidungs- und Rekristallisierungsvorgängen, die die Gefügestruktur eines herzustellenden Materials beeinflussen. Ein so entstehendes Bauteil, wie z.B. ein Guss-Bauteil, ist in seiner Gefügestruktur inhomogen und weist folglich ein heterogenes Gefüge auf.

Um die Eigenschaften eines verwendeten Materials hinsichtlich seiner Festigkeit, seiner Plastizität bzw. seiner Sprödigkeit, seiner Elastizität und einiger anderer Eigenschaften genau zu bestimmen, werden Materialproben in einem Zugversuch getestet, indem die Probe mit bekanntem Ausgangsquerschnitt in eine Zugprüfmaschine eingespannt und mit einer Zugkraft belastet wird. Dabei ist die Zugfestigkeit die Spannung, die im Zugversuch aus der maximal erreichten Zugkraft bezogen auf den ursprünglichen Querschnitt der Probe errechnet wird. In einem Spannungs-Dehnungs-Diagramm kann die Zugfestigkeit (Y-Achsen-Wert am höchsten Punkt) direkt abgelesen werden. Die Streckgrenze ist ein Werkstoffkennwert und bezeichnet diejenige Spannung, bis zu der ein Werkstoff bei einachsiger und momentenfreier Zugbeanspruchung keine sichtbare plastische Verformung zeigt. Bei Überschreiten der Streckgrenze kehrt das Material nach Entlastung nicht mehr in die ursprüngliche Form zurück, sondern eine Probenverlängerung verbleibt. Die Streckgrenze und eine Zugfestigkeit wird gewöhnlich im Zugversuch ermittelt. Beide Werkstoffkennwerte liefern für die Konstruktion eines Bauteils Information über den Abstand zwischen einsetzender plastischer Deformation und Versagen des Werkstoffes bei quasistatischer Beanspruchung.

Nach einer Ausführungsform der Erfindung wird ferner mittels einer computergestützten Erstarrungssimulation ein Prozess zum Gießen des Prototyps optimiert, wobei bei der Optimierung die Gefügestruktur durch wiederholte Simulation so angepasst wird, dass die lokale Härte des Prototyps innerhalb der ersten Toleranzgrenze liegt.

Dies kann den Vorteil haben, dass die Modalitäten des Gießprozesses eines Prototyps vorbereitend schon so weit im Voraus und im Detail geplant werden können, dass eine geforderte lokale Härte eines Prototyps mit hoher Wahrscheinlichkeit schon in den ersten Versuchen des Gießens erreicht werden kann. Die Anzahl an Material und Zeit verschwendenden Versuchen beim Gießen und an aufwendigen realen Messungen und Prüfmethoden wird erheblich reduziert.

Dabei ist eine Erstarrungssimulation eine rechnergestützte Simulation eines Gießvorganges. Hiermit kann man bereits im Vorfeld einer Gussstückentwicklung evtl. auftretende Schwachstellen hinsichtlich des Einströmverhaltens des flüssigen Metalls in den Formhohlraum bzw. im Einguss-Lauf-Anschnittsystem (wie z.B. Turbulenzen), des Abkühlverhaltens (z.B. Gussstückbereiche mit hoher Lunkerneigung), etc. ausfindig machen und somit relativ kostengünstig Veränderungen am Gussstück bzw. am Einguss-Lauf-Anschnittsystem vornehmen. Die Erstarrungssimulation ersetzt eine Vielzahl von unvermeidlichen Praxistests.

Die Berechnungen der computergestützten Simulation und die der Erstarrungssimulation wirken synergistisch, indem die computergestützte Simulation primär die Gestaltungsparameter des Guss-Bauteils optimiert und die Erstarrungssimulation primär die Gießbedingungen optimiert.

Nach einer Ausführungsform der Erfindung weist die Gefügestruktur ein lokales Gefüge auf, wobei mittels der computergestützten Erstarrungssimulation das lokale Gefüge des Prototyps aus einer Verteilung und einer Größe von Gefügeungänzen der Gefügestruktur direkt berechnet wird.

Dies kann den Vorteil haben, dass die Erstarrungssimulation eine Vorhersage von Gefügeungänzen bei ungünstigen Gießbedingungen liefert. Die Erstarrungssimulation kann den Ort und die Größe von Gefügeungänzen in Abhängigkeit von den Parametern des Gießprozesses vorausschauend berechnen. Bei der Erstarrungssimulation können die Parameter des Gießens und auch die Auslegungsparameter des simulierten Prototyps für das herzustellende Guss-Bauteil so variiert werden, dass ein Auftreten von Gefügeungänzen in der Gefügestruktur des simulierten Prototyps beim Gießen vermieden werden. Die Gießbedingungen sowie die geometrische Form und/oder eine lokale Topologie des Prototyps können noch vor einem realen physikalischen Gießprozess ohne jeglichen Materialverbrauch weitgreifend und gezielt optimiert werden.

Nach einer Ausführungsform der Erfindung umfassen die vorgegebenen Kennwerte für die mechanische Beanspruchung hinsichtlich der Beanspruchung mechanische Kennwerte, Gestaltparameter, Belastungsparameter und/oder Dimensionierungsparameter, und hinsichtlich einer Beanspruchbarkeit Gefügestrukturparameter, Parameter für eine lokale Ermüdungsfestigkeit, Güteklassen, und/oder vordefinierte Referenzflächen.

Dies kann den Vorteil haben, dass zur Bestimmung einer lokalen Härte eines Prototyps eine Vielzahl von Beziehungen zwischen den verschiedenen Kennwerten hergestellt werden können. Ursache und Wirkung von Veränderungen von Kennwerten können aus verschiedenen Perspektiven und durch verschiedene Ansätze quantifiziert und analysiert werden. Dabei werden Form- und Gefügestrukturparameter des Prototyps als auch Art und Weise der mechanischen Belastung sowie die Zeitdauer der Beanspruchung berücksichtigt. Dadurch können alle möglichen Einflussfaktoren einer lokalen Härte bestimmt werden. Hieraus wiederum lassen sich gezielt adäquate Maßnahmen zur Realisierung einer geforderten lokalen Härte ableiten, so dass entweder die Beanspruchbarkeit steigt oder die Beanspruchung sinkt.

In diesem Kontext wird Ermüdungsfestigkeit als Oberbegriff zu Schwingfestigkeit und Betriebsfestigkeit verwendet. Dabei bezeichnet Schwingfestigkeit die Ermüdungsfestigkeit bei periodisch wiederholten Belastungen, insbesondere bei sinusähnlichem Lastablauf. Betriebsfestigkeit umfasst die Ermüdungsfestigkeit bei zufallsartig oder auch aperiodisch deterministischem Lastablauf.

Nach einer Ausführungsform der Erfindung umfasst das Verfahren ferner eine computergestützte Berechnung einer lokalen Festigkeit des aus Schritt e) gewonnenen Prototyps, wobei die Berechnung der lokalen Festigkeit eine Berechnung einer lokalen statischen Festigkeit, einer lokalen Betriebsfestigkeit und/oder einer lokalen Schwingfestigkeit umfasst, wobei die Berechnung der lokalen Festigkeit auf Werten für gemessene Kennwerte für mechanische Beanspruchung basiert, welche durch Messungen an einem real gegossenen aus Schritt e) gewonnenen Prototyp und/oder an einem repräsentativen Guss-Bauteil gewonnen wurden.

Dies kann den Vorteil haben, dass bei der Berechnung der lokalen Festigkeit des aus Optimierungsberechungen gewonnenen Prototyps die Art und Weise der mechanischen Beanspruchung differenziert wird. Sowohl eine statische konstante Belastung als auch eine sich periodisch oder aperiodisch sich verändernde Last werden bei der Bestimmung der lokalen Festigkeit des Prototyps berücksichtigt. Dies ermöglicht eine Szenarioanalyse und Einbeziehung von Eventualitäten, aus denen angeleitet werden kann, wie der Prototyp in seiner Ausgestaltung und Gefügestruktur idealerweise beschaffen sein sollte, um robust gegen jede Art von mechanischer Belastung zu sein und um die Lebensdauer des herzustellenden Guss-Bauteils auch bei verschiedenen Arten von Belastungen zu verlängern. Dabei werden die optimalen Parameter nicht nur aus computergestützten Berechnungen angeleitet, sondern auch durch physikalische Messungen an dem real gegossenen, mittels der vorhergehenden Berechnungen schon optimierten Prototyps und/oder an repräsentativen Guss-Bauteilen mit vergleichbaren Materialeigenschaften verifiziert. Gemessene Werte können auch als Eingabeparameter für Variablen in die computergestützten Berechnungen mit eingehen, so dass die Abweichungen zwischen theoretisch berechneten und tatsächlichen realen Werten minimiert werden. Dadurch wird die Gültigkeit der computergestützten Berechungen für die lokale Festigkeit erhöht. Die Wahrscheinlichkeit, dass einzuleitende Maßnahmen zur Erhöhung einer lokalen Festigkeit des Prototyps auch tatsächlich eine Steigerung der lokalen Festigkeit bewirken, wird dadurch erhöht. Nach einer Ausführungsform der Erfindung wird die computergestützte Berechnung der lokalen Festigkeit und/oder der virtuellen Beanspruchungsanalyse verifiziert durch Messungen an dem real gegossenen aus Schritt e) gewonnenen Prototyp und/oder an dem repräsentativen Guss-Bauteil, wobei im Falle, dass eine Verifikation mittels den Messungen fehlschlägt, die gewonnenen Messwerte als Grundlage für eine korrektive Anpassung der Kennwerte für die mechanische Beanspruchung und/oder der Kennwerte für die Beanspruchbarkeit in der computergestützte Berechnung der lokalen Festigkeit und/oder der virtuellen Beanspruchungsanalyse dienen.

Dies kann den Vorteil haben, dass die Gültigkeit und die Verlässlichkeit der Ergebnisse der computergestützten Berechnungen und der virtuellen Beanspruchungsanalyse erhöht werden. Eine mögliche Abweichung zwischen den computergestützten Berechnungen, die auf modellhaften Annahmen und Annäherungswerten basieren, und den tatsächlich am realen Objekt des Prototyps vorliegenden Kennwerten wird durch die zur Verifikation dienenden Messungen möglichst weitgehend reduziert. Gleichzeitig können große Abweichungen zwischen berechneten Werten und tatsächlich gemessenen Werten dazu benutzt werden, Parameter in den computergestützten Berechnungen so zu variieren, dass das Modell noch stärker der Realität entspricht und/oder die Materialeigenschaften des simulierten Prototyps so anzupassen, dass die geforderte lokale Festigkeit des Prototyps erreicht wird.

Nach einer Ausführungsform der Erfindung werden durch die Erstarrungssimulation Werte für die statische Festigkeit, die lokale Betriebsfestigkeit und/oder die lokale Schwingfestigkeit des simulierten Prototyps berechnet, wobei diese Werte verifiziert werden durch Messwerte, welche in lokalen Härtemessungen, Schwingfestigkeitstests und/oder lokalen Mikrostrukturuntersuchungen an einem aus der Erstarrungssimulation abgeleiteten und abgegossenen physisch realen Prototyp und/oder an dem repräsentativen Bauteil gemessen werden, wobei im Falle, dass eine Verifikation mittels den Messungen fehlschlägt, gewonnene Messwerte aus den lokalen Härtemessungen, Schwingfestigkeitstests und/oder lokalen Mikrostrukturuntersuchungen als Grundlage für eine korrektive Anpassung der durch die Erstarrungssimulation berechneten Werte für die statische Festigkeit, die lokale Betriebsfestigkeit und/oder die lokale Schwingfestigkeit dienen.

Dies kann den Vorteil haben, dass die Gültigkeit und die Verlässlichkeit der Ergebnisse der computergestützten Erstarrungssimulation erhöht werden. Eine mögliche Abweichung zwischen den Ergebnissen der Erstarrungssimulation, die auf vereinfachenden Annahmen und modellhaften Annäherungswerten basiert, und den tatsächlich am realen Objekt des Prototyps gemessenen Kennwerten wird durch die zur Verifikation dienenden Messungen möglichst weitgehend reduziert. Gleichzeitig können große Abweichungen zwischen berechneten Werten und tatsächlich gemessenen Werten, dazu benutzt werden, Parameter in der Erstarrungssimulation so zu variieren, dass das der Erstarrungssimulation zugrunde liegende Modell noch stärker der Realität entspricht. Berechnete Parameter des simulierten Gießprozesses hätten dann eine größere Gültigkeit und Verlässlichkeit hinsichtlich ihrer Übertragbarkeit auf den realen Gießprozess.

Nach einer Ausführungsform der Erfindung erfolgt ferner ein Schritt einer computergestützten Abfrage einer Datenbank (152) mit der lokalen mechanischen Beanspruchung des simulierten Prototyps (106), wobei die Abfrage als Antwort ein geeignetes Prüfkonzept (150) zur Prüfung der lokalen Ermüdungsfestigkeit des physisch real gegossenen aus Schritt e) gewonnenen Prototyps (142) und/oder des repräsentativen Guss-Bauteils (144) ergibt, wobei das Verfahren ferner eine Bestimmung umfasst, an welcher Stelle des physisch realen aus Schritt e) gewonnenen Prototyps (142) und/oder des repräsentativen Guss-Bauteils (144) eine Prüfung der lokalen Ermüdungsfestigkeit mittels des Prüfkonzepts (150) vorzunehmen ist.

Dies kann den Vorteil haben, dass nach einer geeigneten Prüfmethode nicht mehr gesucht werden muss. Gleichzeitig wird die Information geliefert, an welcher Stelle des gegossenen Prototyps genau Belastungstests und Messungen vorzunehmen sind. Dies erspart Zeit und macht den Prüfprozess effizienter.

Die Verifikation der Berechnungen durch Messungen und die Lieferung eines geeigneten Prüfkonzepts haben den synergistischen Effekt, dass die aus dem jeweiligen Prüfungskonzept abgeleiteten lokal vorgenommenen Messungen einen hohen Grad an Gültigkeit und Zuverlässlichkeit haben. Die aus einem Prüfkonzept abgeleiteten Messungen sind damit effektiv und effizient zugleich.

Nach einer Ausführungsform der Erfindung erfolgt die Berechnung der lokalen statischen Festigkeit aus einer Korrelation zwischen der Streckgrenze und/oder der Zugfestigkeit und der Härte eines real gegossenen aus Schritt e) gewonnenen Prototyps und/oder des repräsentativen Guss-Bauteils,
- wobei die Berechnung der lokalen Betriebsfestigkeit mittels eines Wöhlerlinienmodells erfolgt, welches mit dem Gefüge des gegossenen aus Schritt e) gewonnenen Prototyps und/oder des repräsentativen Guss-Bauteils korreliert, wobei ein Einfluss der Gefügeungänzen auf die Schwingfestigkeit berücksichtigt wird, und/oder
- wobei in die Berechnung der lokalen Schwingfestigkeit des aus Schritt e) gewonnenen Prototyps und/oder des repräsentativen Guss-Bauteils Messwerte zur Schwingfestigkeit eingehen, die mittels einer geeigneten Prüfmethode zum Schwingfestigkeitsnachweis an dem aus Schritt e) gewonnenen Prototyps gemessen werden.

Dies kann den Vorteil haben, dass im Falle, dass der gegossene Prototyp eine Korrelation zwischen der Streckgrenze und/oder der Zugfestigkeit und der Härte aufweist, die lokale statische Festigkeit aus einem materialspezifischen Spannungs-Dehnungs-Diagramm ermittelt werden kann. Diese so ermittelten Werte für die lokale Härte können durch einfache lokale Härtemessungen am gegossenen Prototyp verifiziert werden.

Dies kann weiterhin den Vorteil haben, dass im Falle, dass für den gegossenen Prototyp ein Wöhlerlinienmodell vorliegt, welches mit der Gefügestruktur des Prototyps korreliert, und bei Kenntnis des Einflusses von Gefügeungänzen hinsichtlich ihrer Form, Lage, Größe und Anzahl, eine Umrechnung von statischen Probekennwerten auf Schwingfestigkeiten des Guss-Bauteils, welche sonst sehr ungenau sind, vollständig entfallen könnte. Denn wenn das Wöhlerlinienmodell für den Prototyp gilt, kann die lokale Schwingfestigkeit des Guss-Bauteils mittels einfacher Prüfmethoden ermittelt werden. Bei Geltung des Wöhlerlinienmodells können lokale Kennwerte zur Ermittlung der Betriebsfestigkeit mittels lokaler Gefügeabdrücke und/oder einer lokalen Gefügemikroskopie ermittelt werden.

Mit einem Wöhlerversuch wird die Schwingfestigkeit, genauer die Zeitfestigkeit und Dauerfestigkeit von Werkstoffen oder Bauteilen ermittelt. Hierfür werden die Versuchskörper zyklisch, meist unter einer sinusförmigen Beanspruchungs-ZeitFunktion, belastet. Die Lastamplituden sowie das Spannungsverhältnis aus Unterlast zu Oberlast sind konstant. Zur Ermittlung der Werte werden die Versuchskörper auf mehreren Lasthorizonten geprüft. Der Wöhlerversuch läuft, bis ein definiertes Versagen (Bruch, Anriss) eintritt oder eine festgelegte Anzahl Schwingungen überstanden wird. Die Ergebnisse des Versuchs trägt man in ein Diagramm ein. Üblicherweise wird im Wöhlerdiagramm die Nennspannungsamplitude Sa linear oder logarithmisch über der logarithmisch dargestellten, ertragbaren Schwingspielzahl aufgetragen. Den sich ergebenden Kurvenzug nennt man die Wöhlerkurve oder auch Wöhlerlinie. Nach einer Ausführungsform der Erfindung werden bei den computergestützen Berechnungen und bei der computergestützten Erstarrungssimulation für Zustände der Gefügestruktur und/oder Gefügeungänzen der Gefügestruktur des aus Schritt e) gewonnenen Prototyps vordefinierte dritte Toleranzgrenzen vorgegeben, wobei im Falle, dass dritte Toleranzgrenzen nicht eingehalten werden, die Schritte a bis e, die Messungen und/oder die Erstarrungssimulation so lange wiederholt werden bis die Zustände der Gefügestruktur und/oder Gefügeungänzen der Gefügestruktur innerhalb der vordefinierten dritten Toleranzgrenzen liegen.

Dies kann den Vorteil haben, dass schon auf Ebene der theoretischen Computerberechnungen und auf Ebene der Erstarrungssimulation einzuhaltende Qualitätsanforderungen bezüglich der Beschaffenheit der Gefügestruktur des herzustellenden Guss-Bauteils berücksichtigt werden. Neben einer Optimierung der Formgebung des herzustellenden Guss-Bauteils findet auch eine Optimierung und Qualitätskontrolle hinsichtlich der Gefügestruktur statt, um eine benötigte lokale Härte zu erreichen. Gleichzeitig wird bei der Erstarrungssimulation festgestellt, unter welchen Gießbedingungen eine optimierte Gefügestruktur zu erzielen ist, so dass in dieser Phase die idealen Werte für die Parameter des realen Gießprozess bestimmt werden können.

In einem weiteren Aspekt betrifft die Erfindung ein Computerprogrammprodukt mit von einem Prozessor ausführbaren Instruktionen zur Durchführung des obig beschriebenen Verfahrens.

In einem weiteren Aspekt betrifft die Erfindung ein Computersystem zur Optimierung eines Guss-Bauteils mit heterogenem Gefüge unter Berücksichtigung von Anforderungen hinsichtlich einer lokalen Härte zum Zwecke einer Herstellung eines Guss-Bauteils, wobei das Computersystem ausgebildet iat zur Durchführung folgender Schritte:
- computergestützte Simulation eines Prototyps des Guss-Bauteils unter Vorgabe von Kennwerten für eine mechanische Beanspruchung und eine benötigte lokale Härte des Guss-Bauteils,
- virtuelle Beanspruchungsanalyse des simulierten Prototyps für das Guss-Bauteil zur Ermittlung einer simulierten lokalen Härte des Guss-Bauteils, wobei eine Streckgrenze und eine Zugfestigkeit lokaler Punkte des Prototyps simuliert werden, wobei sich aus der Streckgrenze und/oder der Zugfestigkeit die simulierte lokale Härte ergibt, wobei durch Vergleich der lokalen Härte und der simulierten lokalen Härte Schwachstellen im Prototyp bestimmt werden, wobei die Schwachstellen dadurch identifiziert werden, dass eine erste Toleranzgrenze der lokalen Härte überschritten wird,
- Wiederholung der Schritte a bis b bis die vordefinierten Grenzwerte eingehalten werden, wobei der Prototyp hinsichtlich der lokalen Härte optimiert wird,
- Berechnung von lokalen Strukturveränderungen des optimierten Prototyps nach Wirkung der mechanischen Beanspruchung, wobei in die Berechnung die simulierte lokale Härte eingeht, wobei der optimierte Prototyp zur Vermeidung der Strukturveränderungen weiter optimiert wird durch Anpassung der benötigten lokalen Härte, einer Gefügestruktur und/oder einer geometrischen Form des Prototyps,
- Wiederholung der Schritte a bis d so lange bis alle Strukturveränderungen innerhalb vordefinierter zweiter Toleranzgrenzen liegen.

Im Folgenden werden bevorzugte Ausführungsformen der Erfindung anhand der folgenden Zeichnungen näher erläutert.

Es zeigen:
- Figur 1:: ein Guss-Bauteil mit heterogener Gefügestruktur,
- Figur 2:: ein Flussdiagramm mit Verfahrensschritten zur Identifizierung von lokalen Schwachstellen bezüglich einer geforderten benötigten lokalen Härte,
- Figur 3:: ein Flussdiagramm zur Veranschaulichung der Abhängigkeit der Verfahrensschritte zur Optimierung der lokalen Härte,
- Figur 4: ein Flussdiagramm zur Veranschaulichung der Verifikation der computergestützten Berechnungen durch Messungen.

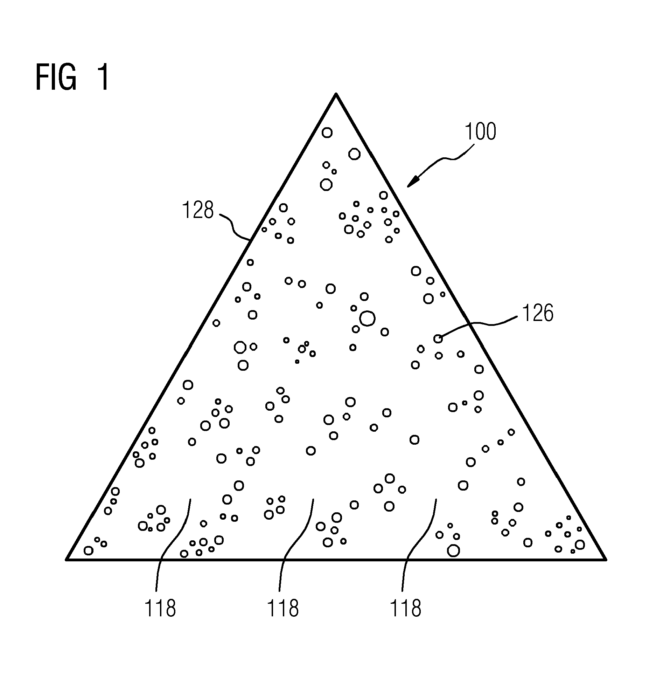

Die Figur 1 zeigt ein Guss-Bauteil 100 mit heterogener Gefügestruktur 126. Beispielsweise könnte es sich um ein Bauteil aus Gusseisen mit Kugelgraphit nach DIN EN 1563 handeln. Lokal treten verstreut Gefügeungänzen 118 in der Gefügestruktur 126 auf, welche Schwachstellen bezüglich einer benötigten lokalen Härte gegen eine Extremlast und/oder eine Ermüdung darstellen. Zur Erreichung einer geforderten lokalen Härte 102 ist somit eine Optimierung der Gefügestruktur 126 erforderlich. Das Guss-Bauteil 100 zeigt eine bestimmte geometrische Form 128 auf, welche zur Erzielung einer bestimmten geforderten mechanischen Beanspruchbarkeit 108 ebenfalls optimiert werden könnte.

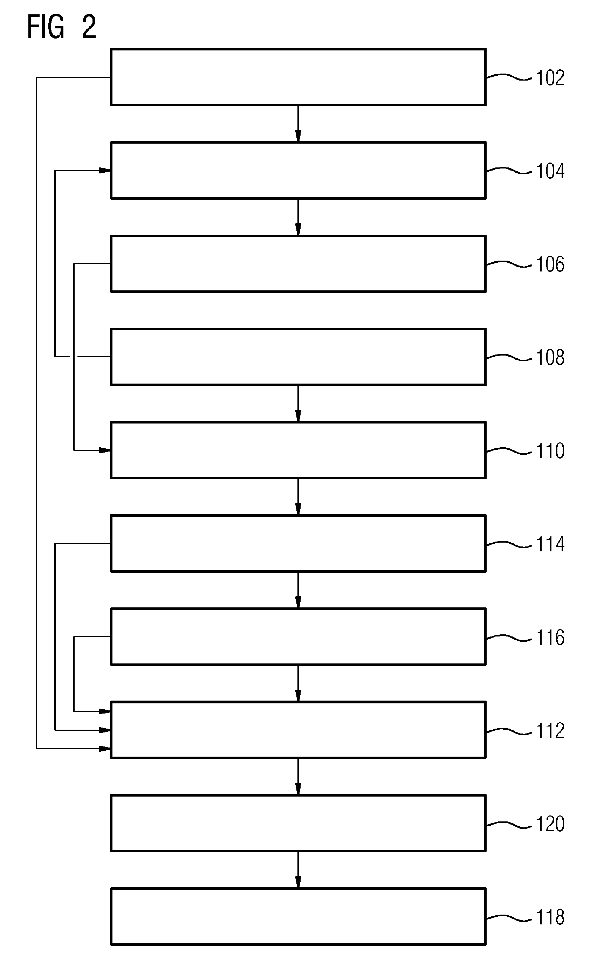

Die Figur 2 zeigt ein Flussdiagramm zur Demonstration wie Gefügeungänzen 118 bzw. Schwachstellen hinsichtlich einer geforderten lokalen Härte 102 in einem simulierten Prototyp 106, welcher mittels einer computergestützten Simulation 104 berechnet wird, identifiziert werden können.

In Schritt 102 wird eine bestimmte lokale Härte eines noch herzustellenden Guss-Bauteils 100 mittels spezieller Anforderungen hinsichtlich einer geforderten mechanischen Beanspruchbarkeit 108 als Vorgabe in die computergestützte Simulation 104 zur Berechnung eines optimierten Prototyps 106 eingegeben. Ebenso werden in Schritt 108 vordefinierte Kennwerte für eine mechanische Beanspruchbarkeit für die computergestützte Simulation 104 zur Berechung eines bezüglich der lokalen Härte optimierten simulierten Prototyps 106 vorgegeben.

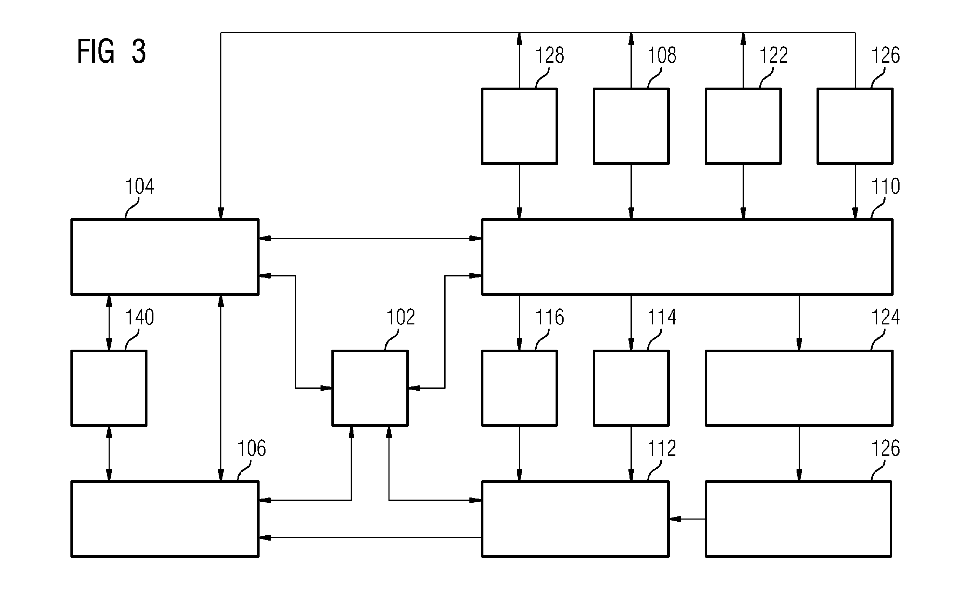

Bei der computergestützten Simulation 104 wird eine lokale Beanspruchung 122 bestimmt. Details hierzu sind in Figur 3 gezeigt. Z.B. mittels einer sogenannten FEM Simulation, d.h., mittels einer Finite-Elemente-Methode (FEM) kann Schritt 104 durchgeführt werden. Die "Methode der finiten Elemente" ist ein numerisches Verfahren zur Lösung von partiellen Differentialgleichungen. Sie stellt ein Berechnungsverfahren zur Simulation von Festkörpern dar. Zunächst wird das Berechnungsgebiet in eine beliebig große Anzahl von Elementen unterteilt. Diese Elemente sind "endlich" (finit) und nicht unendlich (infinit) klein. Das Verfahren liefert eine Näherungsfunktion an die exakte Lösung einer Differentialgleichung, deren Genauigkeit durch die Erhöhung der Freiheitsgrade und damit des Rechenaufwandes verbessert werden kann.

Ein Ziel der computergestützten Simulation 104 ist die Optimierung der geometrischen Form 128 des simulierten Prototyps 106 zur Erreichung der benötigten lokalen Härte 102.

Dabei werden im Material vorherrschende Spannungen in Abhängigkeit von der geometrischen Struktur 128 und der Gefügestruktur 126 errechnet und anschließend durch einen gezielten Kerbspannungsabbau sowie eine Spannungshomogenisierung optimiert. Das gemäß dem optimierten Prototyp 106 noch herzustellende Guss-Bauteil 100 soll dadurch einer geforderten mechanischen Beanspruchbarkeit 108 und einer vorgegebenen mechanischen Beanspruchung 122 standhalten und somit dauerfest sowie langlebiger werden. Ziel der computergestützten Simulation 104 ist somit, stark beanspruchte Stellen des simulierten Prototyps 106 zu verstärken und weniger beanspruchte Stellen zurück zu bilden.

Der durch Optimierung der geometrischen Form 128 und durch Optimierung der Gefügestruktur 126 sich aus der computergestützten Simulation 104 ergebende simulierte Prototyp 106 wird in einem nächsten Schritt einer computergestützten virtuellen Beanspruchungsanalyse 110 unterzogen. Bei der virtuellen Beanspruchungsanalyse 110, bei der durch virtuelles Strecken und Ziehen des simulierten Prototyps 106 dessen virtuelle Streckgrenze 114 und dessen virtuelle Zugfestigkeit 116 ermittelt wird, erfolgt durch eine vorgegebene Korrelation zwischen Streckgrenze und/oder Zugfestigkeit zur lokalen Härte, eine Bestimmung der lokalen Härte in Abhängigkeit von der geometrischen Form 128 und der Gefügestruktur 126 des simulierten Prototyps 106. Unter Berücksichtigung einer ersten Toleranzgrenze 120 können so lokale Gefügeungänzen und/oder andersartige Schwachstellen bezüglich einer lokalen Festigkeit gegen Extremlast und/oder eine Ermüdungsfestigkeit im simulierten Prototyp 106 identifiziert werden.

Wie in Figur 3 ersichtlich, werden als mögliche Input-Parameter für die virtuelle Beanspruchungsanalyse 110 z.B. die geometrische Form 128, vorgegebene Kennwerte für eine mechanische Beanspruchbarkeit 108, eine vorgegebene mechanische Beanspruchung 122, verschiedene Zustände einer Gefügestruktur 126 und/oder eine benötigte lokale Härte 102 vorgegeben. Mittels der virtuellen Beanspruchungsanalyse 110 werden dann eine lokale Zugfestigkeit 116, eine lokale Streckgrenze 114, lokale Strukturveränderungen 124 des simulierten Prototyps 106 und verschiedene Zustände der Gefügestruktur 126 nach Veränderung neu berechnet. Dabei können Strukturveränderungen auch z.B. eine irreversible plastische Verformung oder einen Bruch umfassen.

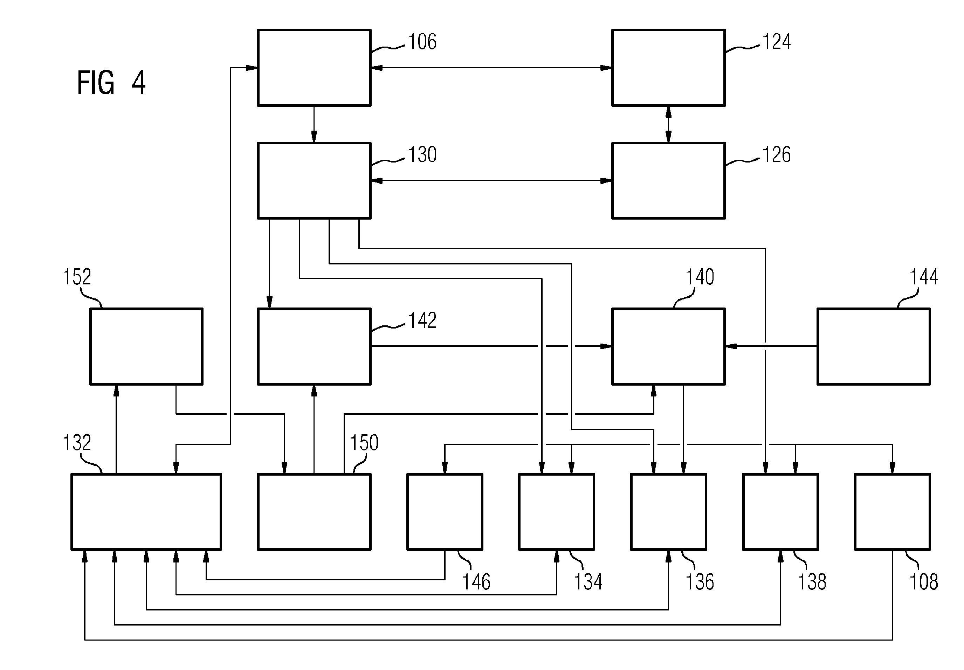

Die Berechnungen der virtuellen Beanspruchungsanalyse 110 ergeben eine simulierte notwendige lokale Härte 102 des simulierten Prototyps 106. Mittels Messungen 140 an Referenzkörpern mit ähnlichen Materialeigenschaften, z.B. repräsentativen Guss-Bauteilen 144, werden, wie in Figur 4 dargestellt, werden die berechneten Werte verifiziert. Sollte eine Verifikation der berechneten Werte mittels vergleichender Messungen 140 fehlschlagen, so dienen die realen Messwerte als Grundlage für die neu einzugebenden Input-Parameter, z.B. die Kennwerte für eine mechanische Beanspruchbarkeit 108, mechanische Beanspruchung 122, Gefügestruktur 126 und/oder geometrische Form 128, für die computergestützte Simulation 104 und die virtuelle Beanspruchungsanalyse 110. Auch zur computergestützten Berechnung einer lokalen Ermüdungsfestigkeit des Prototyps 106 werden Messwerte eingeben, die aus Messungen stammen, bei denen Proben aus separaten und/ oder angegossenen Probekörpern aus verschiedenen Bauteilbereichen des Prototyps und/oder des Bauteils entnommen und untersucht werden.

Eine mögliche signifikante Abweichung zwischen theoretisch berechneten Werten und real gemessenen Messwerten wird durch wiederholte Verifikation mittels Messungen 140 an Referenzkörpern verringert. Die Gültigkeit und Verlässlichkeit der mittels der computergestützten Simulation 104 und mittels der virtuellen Beanspruchsanalyse 110 berechneten Werte für die lokale Zugfestigkeit 116, die lokale Streckgrenze 114, lokale Strukturveränderungen 124 und/oder die benötigte lokale Härte 102 wird dadurch erhöht.

Beim Konzipieren eines geeigneten Guss-Bauteils 100 kann mittels der Erstarrungssimulation 130 ergänzend das lokale Gefüge 126 mit einer Verteilung und Größe von Gefügeungänzen 118 berechnet werden, was in Figur 4 dargestellt ist. Dadurch können wiederum indirekt die statische lokale Festigkeit 134 und die lokale Schwingfestigkeit 138 berechnet werden.

Wenn alle Kriterien hinsichtlich einer geforderten lokalen Härte 102 erfüllt sind, kann ein erster physisch realer Prototyp 142 gegossen werden. An diesem Prototyp sind ebenfalls sämtliche Messungen 140 durchzuführen, um die Simulationen erneut zu verifizieren, wie in Figur 4 dargestellt.

Aus den lokalen Beanspruchungen des simulierten Prototyps 106 ist dabei jeweils ein adäquates Prüfkonzept 150 abzuleiten. Dabei könnte beispielsweise - wie in Figur 4 angedeutet - mittels einer Datenbankabfrage 152 automatisch von den Ergebnissen der computergestützten Berechnungen der lokalen Festigkeit des simulierten Prototyps 106 ein geeignetes Prüfkonzept 150 abgerufen und signalisiert werden. Ein solches Prüfkonzept 150 sollte definieren, an welchen Stellen eines physisch real gegossenen Prototyps 142 und/oder eines repräsentativen Guss-Bauteils 144 welche Messungen 140 erforderlich sind, um die Funktionsfähigkeit des herzustellenden Guss-Bauteils 100 sicherzustellen. Dies ist z.B. mittels einer Kennzeichnung in einer Prüfzeichnung möglich. Lokale Bauteileigenschaften können in Zeichnungen angezeigt und/oder auf einem Computerbildschirm ausgegeben werden. Für die Ermittlung der lokalen statischen Festigkeit 134 sowie der lokalen Schwingfestigkeit 138 wären beispielsweise aus separaten Probekörpern oder angegossenen Proben Körper zu entnehmen.

Wenn die erforderliche lokale Härte 102 nicht erreicht werden sollte, so kann das Guss-Bauteil 100 dadurch optimiert werden, dass entweder die Beanspruchung gesenkt wird und/oder die lokale Beanspruchbarkeit gesteigert wird. Auch ein nachträgliches Perlitisieren des physisch real gegossenen Prototyps oder des herzustellenden Guss-Bauteils wäre möglich, um eine ausreichende lokale Härte zu erzielen. Dabei bedeutet "Perlitisierung" eine Erzielung einer möglichst vollständigen perlitischen Gefügestruktur bei Gusseisenlegierungen und/oder Stahl durch eine Wärmebehandlung. Dabei können Änderungen der Zusammensetzung der einzelnen Legierungsbestandteile des Guss-Bauteils (z. B. des C- oder N-Gehaltes) herbeigeführt werden.

Zeigen alle gemessenen Kennwerte der lokalen Festigkeit 102, 108, 134, 136, 138 des physisch real gegossenen Prototyps eine gute Übereinstimmung mit den Ergebnissen der computergestützten Berechung 132 und der computergestützten Simulation 104 und bereits bekannten Werten, gewonnen an repräsentativen Guss-Bauteilen 144, so könnte bei der Produktion des Guss-Bauteils 100 in Serie ein deutlich reduzierter Prüfumfang gefahren werden.

Ein weiterer Vorteil von Ausführungsformern der Erfindung ist, dass sich z.B. eine Qualitätskontrolle von Guss-Bauteilen reduzieren ließe auf eine lokale Überprüfung von kritischen Stellen im Guss-Bauteil, an denen eine hohe lokale mechanische Beanspruchung stattfindet. Denn gerade Strukturbauteile aus z.B. Gusseisen werden häufig nur an wenigen lokalen kleinen Stellen hoch beansprucht. Weniger beanspruchte Bereiche eines Guss-Bauteils benötigen daher eigentlich eine reduzierte Qualitätsprüfung. Ausführungsformern der Erfindung könnten dies auf vorteilhafte Weise gewährleisten.

Auch eine Berechnung einer Auslegung eines groß dimensionierten Guss-Bauteils ließe sich auf einige wenige relevante kritische Stellen des Guss-Bauteils reduzieren. Bei Serienteilen oder Bauteilen mit nur geringfügigen Änderungen der Geometrie wäre es durch Ausführungsformen der Erfindung möglich, die aufwendigen Messungen durch Simulationen des Gießprozesses mittels einer Erstarrungssimulation zu ersetzen. Dabei wäre es wiederum zwingend erforderlich, die Gussimulation an Probekörpern zu verifizieren.

Mittels computergestützter Optimierung der geometrischen Form und der lokalen Gefügestruktur ermöglichen Ausführungsformen der Erfindung eine Verbesserung von Funktion und Festigkeit sowie ein Höchstmaß an Materialeffizienz bei der Produktion.

## Patentansprüche

1. Verfahren zur Optimierung eines Guss-Bauteils (100) mit heterogenem Gefüge unter Berücksichtigung von Anforderungen hinsichtlich einer lokalen Härte (102) zum Zwecke einer Herstellung eines Guss-Bauteils (100), aufweisend folgende Verfahrensschritte:
a. computergestützte Simulation (104) eines Prototyps (106) des Guss-Bauteils unter Vorgabe von Kennwerten für eine mechanische Beanspruchung (108) und eine benötigte lokale Härte (102) des Guss-Bauteils (100),
b. virtuelle Beanspruchungsanalyse (110) des simulierten Prototyps (106) für das Guss-Bauteil (100) zur Ermittlung einer simulierten lokalen Härte (112) des Guss-Bauteils (100), wobei eine Streckgrenze (114) und eine Zugfestigkeit (116) lokaler Punkte des Prototyps (106) simuliert werden, wobei sich aus der Streckgrenze (114) und/oder der Zugfestigkeit (116) die simulierte lokale Härte (112) ergibt, wobei durch Vergleich der lokalen Härte (102) und der simulierten lokalen Härte (112) Schwachstellen (118) im Prototyp (106) bestimmt werden, wobei die Schwachstellen dadurch identifiziert werden, dass eine erste Toleranzgrenze (120) der lokalen Härte (112) überschritten wird,
c. Wiederholung der Schritte a bis b bis die vordefinierten Grenzwerte eingehalten werden, wobei der Prototyp (106) hinsichtlich der lokalen Härte (112) optimiert wird,
d. Berechnung von lokalen Strukturveränderungen des optimierten Prototyps nach Wirkung der mechanischen Beanspruchung (122), wobei in die Berechnung die simulierte lokale Härte (112) eingeht, wobei der optimierte Prototyp (106) zur Vermeidung der Strukturveränderungen (124) weiter optimiert wird durch Anpassung der benötigten lokalen Härte (112) und/oder einer Gefügestruktur (126) und/oder einer geometrischen Form (128) des Prototyps (106),
e. Wiederholung der Schritte a bis d so lange bis alle Strukturveränderungen (124) innerhalb vordefinierter zweiter Toleranzgrenzen liegen.

2. Verfahren nach Anspruch 1,
wobei ferner mittels einer computergestützten Erstarrungssimulation (130) ein Prozess zum Gießen des Prototyps (106) optimiert wird, wobei bei der Optimierung die Gefügestruktur (126) durch wiederholte Simulation so angepasst wird, dass die lokale Härte (112) des Prototyps (106) innerhalb der ersten Toleranzgrenze (120) liegt.

3. Verfahren nach Anspruch 2,
wobei die Gefügestruktur (126) ein lokales Gefüge aufweist, wobei mittels der computergestützten Erstarrungssimulation (130) das lokale Gefüge des Prototyps (106) aus einer Verteilung und einer Größe von Gefügeungänzen der Gefügestruktur (126) direkt berechnet wird.

4. Verfahren nach einem der vorhergehenden Ansprüche, wobei die vorgegebenen Kennwerte für die mechanische Beanspruchung (108) hinsichtlich der Beanspruchung mechanische Kennwerte, Gestaltparameter, Belastungsparameter und/oder Dimensionierungsparameter umfassen, und hinsichtlich einer Beanspruchbarkeit Gefügestrukturparameter, Parameter für eine lokale Ermüdungsfestigkeit, Güteklassen, und/oder vordefinierte Referenzflächen umfassen.

5. Verfahren nach Anspruch 1,
wobei das Verfahren ferner eine computergestützte Berechnung einer lokalen Festigkeit des aus Schritt e) gewonnenen Prototyps (106) umfasst, wobei die Berechnung der lokalen Festigkeit eine Berechnung einer lokalen statischen Festigkeit (134), einer lokalen Betriebsfestigkeit (136) und/oder einer lokalen Schwingfestigkeit (138) umfasst, wobei die Berechnung der lokalen Festigkeit auf Werten für gemessene Kennwerte für mechanische Beanspruchung (108) basiert, welche durch Messungen (140) an einem real gegossenen aus Schritt e) gewonnenen Prototyp (142) und/oder an einem repräsentativen Guss-Bauteil (144) gewonnen wurden.

6. Verfahren nach einem der vorhergehenden Ansprüche, wobei die computergestützte Berechnung der lokalen Festigkeit (132) und/oder der virtuellen Beanspruchungsanalyse (110) verifiziert wird durch Messungen (140) an dem real gegossenen aus Schritt e) gewonnenen Prototyp (142) und/oder an dem repräsentativen Guss-Bauteil (144), wobei im Falle, dass eine Verifikation mittels den Messungen (140) fehlschlägt, die gewonnenen Messwerte als Grundlage für eine korrektive Anpassung der Kennwerte für die mechanische Beanspruchung (146) und/oder der Kennwerte für die Beanspruchbarkeit (148) in der computergestützten Berechnung der lokalen Festigkeit (132) und/oder der virtuellen Beanspruchungsanalyse (110) dienen.

7. Verfahren nach einem der vorhergehenden Ansprüche 2 bis 6,
wobei durch die Erstarrungssimulation (130) Werte für die lokale statische Festigkeit (134), die lokale Betriebsfestigkeit (136) und/oder die lokale Schwingfestigkeit (138) des simulierten Prototyps (106) berechnet werden, wobei diese Werte verifiziert werden durch Messwerte (140), welche in lokalen Härtemessungen, Schwingfestigkeitstests und/oder lokalen Mikrostrukturuntersuchungen an einem aus der Erstarrungssimulation abgeleiteten und abgegossenen physisch realen Prototyp (142) und/oder an dem repräsentativen Guss-Bauteil (144) gemessen werden, wobei im Falle, dass eine Verifikation mittels den Messungen (140) fehlschlägt, gewonnene Messwerte aus den lokalen Härtemessungen, Schwingfestigkeitstests und/oder lokalen Mikrostrukturuntersuchungen als Grundlage für eine korrektive Anpassung der durch die Erstarrungssimulation (130) berechneten Werte für die lokale statische Festigkeit (134), die lokale Betriebsfestigkeit (136) und/oder die lokale Schwingfestigkeit (138) dienen.

8. Verfahren nach einem der vorhergehenden Ansprüche, ferner mit dem Schritt einer computergestützten Abfrage einer Datenbank (152) mit der lokalen mechanischen Beanspruchung des simulierten Prototyps (106), wobei die Abfrage als Antwort ein geeignetes Prüfkonzept (150) zur Prüfung der lokalen Ermüdungsfestigkeit des physisch real gegossenen aus Schritt e) gewonnenen Prototyps (142) und/oder des repräsentativen Guss-Bauteils (144) ergibt, wobei das Verfahren ferner eine Bestimmung umfasst, an welcher Stelle des physisch realen aus Schritt e) gewonnenen Prototyps (142) und/oder des repräsentativen Guss-Bauteils (144) eine Prüfung der lokalen Ermüdungsfestigkeit mittels des Prüfkonzepts (150) vorzunehmen ist.

9. Verfahren nach einem der vorhergehenden Ansprüche 5 bis 8,
- wobei die Berechnung der lokalen statischen Festigkeit (134) aus einer Korrelation zwischen der Streckgrenze (114) und/oder der Zugfestigkeit (116) und der Härte (112) eines real gegossenen aus Schritt e) gewonnenen Prototyps (142) und/oder des repräsentativen Guss-Bauteils (144) erfolgt,
- wobei die Berechnung der lokalen Betriebsfestigkeit (136) mittels eines Wöhlerlinienmodells erfolgt, welches mit dem Gefüge des gegossenen aus Schritt e) gewonnenen Prototyps (142) und/oder des repräsentativen Guss-Bauteils (144) korreliert, wobei ein Einfluss der Gefügeungänzen auf die Schwingfestigkeit (138) berücksichtigt wird, und/oder
- wobei in die Berechnung der lokalen Schwingfestigkeit (138) des aus Schritt e) gewonnenen Prototyps (142) und/oder des repräsentativen Guss-Bauteils (144) Messwerte zur Schwingfestigkeit (138) eingehen, die mittels einer geeigneten Prüfmethode (146) zum Nachweis der Schwingfestigkeit (138) an dem aus Schritt e) gewonnenen Prototyps (142) gemessen werden.

10. Verfahren nach einem der vorhergehenden Ansprüche, wobei bei den computergestützen Berechnungen (104, 132) und bei der computergestützten Erstarrungssimulation (130) für Zustände der Gefügestruktur (126) und/oder Gefügeungänzen der Gefügestruktur (126) des aus Schritt e) gewonnenen Prototyps (142) vordefinierte dritte Toleranzgrenzen vorgegeben werden, wobei im Falle, dass dritte Toleranzgrenzen nicht eingehalten werden, die Schritte a bis e, die Messungen und/oder die Erstarrungssimulation so lange wiederholt werden bis die Zustände der Gefügestruktur und/oder Gefügeungänzen der Gefügestruktur innerhalb der vordefinierten dritten Toleranzgrenzen liegen.

11. Computerprogrammprodukt mit von einem Prozessor ausführbaren Instruktionen zur Durchführung der Verfahrensschritte gemäß einem der vorigen Ansprüche.

12. Computersystem zur Optimierung eines Guss-Bauteils (100) mit heterogenem Gefüge unter Berücksichtigung von Anforderungen hinsichtlich einer lokalen Härte (102) zum Zwecke einer Herstellung eines Guss-Bauteils (100), aufweisend folgende Verfahrensschritte:
a. computergestützte Simulation (104) eines Prototyps (106) des Guss-Bauteils unter Vorgabe von Kennwerten für eine mechanische Beanspruchung (108) und eine benötigte lokale Härte (102) des Guss-Bauteils (100),
b. virtuelle Beanspruchungsanalyse (110) des simulierten Prototyps (106) für das Guss-Bauteil (100) zur Ermittlung einer simulierten lokalen Härte (112) des Guss-Bauteils (100), wobei eine Streckgrenze (114) und eine Zugfestigkeit (116) lokaler Punkte des Prototyps (106) simuliert werden, wobei sich aus der Streckgrenze (114) und/oder der Zugfestigkeit (116) die simulierte lokale Härte (112) ergibt, wobei durch Vergleich der lokalen Härte (102) und der simulierten lokalen Härte (112) Schwachstellen (118) im Prototyp (106) bestimmt werden, wobei die Schwachstellen dadurch identifiziert werden, dass eine erste Toleranzgrenze (120) der lokalen Härte (112) überschritten wird,
c. Wiederholung der Schritte a bis b bis die vordefinierten Grenzwerte eingehalten werden, wobei der Prototyp (106) hinsichtlich der lokalen Härte (112) optimiert wird,
d. Berechnung von lokalen Strukturveränderungen des optimierten Prototyps nach Wirkung der mechanischen Beanspruchung (122), wobei in die Berechnung die simulierte lokale Härte (112) eingeht, wobei der optimierte Prototyp (106) zur Vermeidung der Strukturveränderungen (124) weiter optimiert wird durch Anpassung der benötigten lokalen Härte (112) und/oder einer Gefügestruktur (126) und/oder einer geometrischen Form (128) des Prototyps (106),
e. Wiederholung der Schritte a bis d so lange bis alle Strukturveränderungen (124) innerhalb vordefinierter zweiter Toleranzgrenzen liegen.
